# DEMANDE DE BREVET EUROPEEN

(11) **EP 4 576 984 A1**
(43) Date de publication de la demande: **25.06.2025**
(21) Numéro de dépôt: 24222243.8
(22) Date de dépôt: 20.12.2024
(51) Int. Cl.: H10D 1/68, H10N 70/00, H10N 70/20

(54) **DISPOSITIF DE STOCKAGE FERROELECTRIQUE ET PROCEDE DE FABRICATION D'UN TEL DISPOSITIF**

(30) Priorité: 21.12.2023 FR 2314898
(71) Demandeur: Commissariat à l'Energie Atomique et aux Energies Alternatives, 75015 Paris (FR)
(72) Inventeur: BORREL, Julien, 38054 GRENOBLE CEDEX 09 (FR); BARBOT, Justine, 38054 GRENOBLE CEDEX 09 (FR); COIGNUS, Jean, 38054 GRENOBLE CEDEX 09 (FR); GRENOUILLET, Laurent, 38054 GRENOBLE CEDEX 09 (FR); HIDA, Rachid, 38054 GRENOBLE CEDEX 09 (FR); JALAGUIER, Eric, 38054 GRENOBLE CEDEX 09 (FR)
(74) Mandataire: Cabinet Camus Lebkiri

(57) **Abrégé**

L'invention concerne un procédé de fabrication d'un dispositif (1) de stockage ferroélectrique comprenant des étapes de :
- dépôt d'une première couche (2),
- dépôt, par une méthode de dépôt physique en phase vapeur, d'une couche de matériau ferroélectrique (5), la couche de matériau ferroélectrique (5) comprenant une première partie (5A) présentant une première épaisseur (e₁) et une deuxième partie (6 ; 6A) présentant une deuxième épaisseur (e₂), la première épaisseur et la deuxième épaisseur étant distinctes, et
- dépôt d'une deuxième couche (7), la couche de matériau ferroélectrique s'étendant entre la première couche et la deuxième couche (7).

## Description

### DOMAINE TECHNIQUE

La présente invention concerne de manière générale le domaine de la micro-électronique. Elle concerne plus particulièrement le domaine des mémoires non volatiles.

En particulier, l'invention concerne un dispositif de stockage ferroélectrique. Elle concerne également un procédé de fabrication d'un tel dispositif de stockage ferroélectrique.

### ÉTAT DE LA TECHNIQUE

Les mémoires ferroélectriques de type FeRAM (pour « *Ferroelectric Random Access Memory* » selon l'acronyme d'origine anglo-saxonne couramment utilisé) ont pour principale qualité d'être non volatiles, c'est-à-dire de conserver l'information stockée même quand la tension est coupée. Elles présentent également les avantages de consommer peu d'énergie et d'avoir des temps d'écriture et de lecture faibles par rapport à d'autres types de mémoires non volatiles comme les mémoires FLASH.

Les mémoires ferroélectriques de type FeRAM se présentent généralement sous la forme d'un empilement dans lequel une couche de matériau ferroélectrique est positionnée entre deux électrodes métalliques. Les mémoires ferroélectriques sont des mémoires de type capacitif présentant deux états de polarisation rémanente +Pr et - Pr. Le fonctionnement de ces mémoires ferroélectriques repose sur les propriétés ferroélectriques du matériau ferroélectrique placé entre deux électrodes métalliques.

Plus particulièrement, concernant le fonctionnement des mémoires ferroélectriques de type FeRAM, par l'application d'une différence de potentiels entre les deux électrodes créant un champ électrique d'une valeur supérieure à un champ coercitif positif +Ec, la mémoire ferroélectrique est placée dans un état de polarisation rémanente haute +Pr et par l'application d'une différence de potentiels créant un champ électrique d'une valeur inférieure au champ coercitif négatif -Ec, la mémoire ferroélectrique est placée dans un état de polarisation rémanente basse -Pr.

L'état de polarisation rémanente haute +Pr correspond alors à l'état logique binaire '0' et l'état de polarisation rémanente basse -Pr à l'état logique binaire '1', ce qui permet le stockage de l'information.

Par ailleurs, lorsque l'application de la différence de potentiels entre les deux électrodes métalliques est arrêtée, l'état de polarisation rémanente demeure : ceci explique alors le caractère non volatil des mémoires ferroélectriques.

Pour la lecture, il est supposé que la mémoire est dans un état donné et une tension est appliquée. Cette tension est par exemple positive, supérieure à la tension créant un champ électrique d'une valeur supérieure au champ coercitif positif +Ec. Ainsi, si la mémoire était déjà dans l'état de polarisation rémanente haute +Pr, cet état de polarisation est inchangé et aucun pic de courant n'est observé (ou un très faible pic de courant peut être observé). A l'inverse, si la mémoire était dans l'état de polarisation rémanente basse -Pr, un pic de courant beaucoup plus important est observé.

La conséquence de cette opération de lecture est qu'elle est destructrice de l'état de polarisation.

Des mémoires ferroélectriques à jonction tunnel (ou de type FTJ pour *« Ferroelectric Tunnel Junction »* selon l'acronyme d'origine anglo-saxonne couramment utilisé) sont également connues. Les mémoires ferroélectriques de type FTJ se présentent généralement sous la forme d'un empilement dans lequel une couche de matériau ferroélectrique est positionnée entre deux électrodes métalliques. Les mémoires ferroélectriques de type FTJ sont des mémoires de type résistif présentant deux états de polarisation opposés pour la couche de matériau ferroélectrique. Le fonctionnement de ces mémoires ferroélectriques repose sur les propriétés ferroélectriques du matériau ferroélectrique placé entre deux électrodes métalliques.

Plus particulièrement, concernant le fonctionnement des mémoires ferroélectriques de type FTJ, les deux états de polarisation correspondent respectivement à deux niveaux de résistance différents : un niveau fortement résistif, correspondant à par exemple à un état de polarisation haute +Pr et un niveau faiblement résistif, correspondant à un état de polarisation basse -Pr. A titre d'exemple, le niveau faiblement résistif présente une résistance électrique environ mille fois inférieure à celle du niveau fortement résistif.

Dans le cas des mémoires ferroélectriques de type FTJ, l'opération de lecture comprend l'application d'une tension de lecture -Vr. La tension de lecture -Vr est par exemple négative et inférieure en valeur absolue à une tension Vc associée au champ coercitif. Cela permet alors d'effectuer une lecture non-destructive par l'intermédiaire de la mesure d'un courant tunnel.

Afin d'augmenter la densité de mémoire, il est connu de mettre en oeuvre un stockage dit « multi-niveaux ». Ce stockage « multi-niveaux » est associé à différents états de polarisation, sur lesquels il va être possible de mémoriser de l'information.

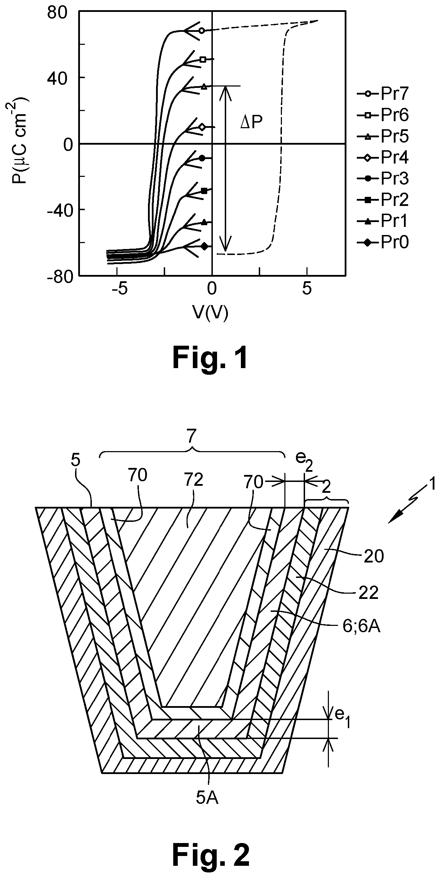

Le document « Multilevel data storage memory using deterministic polarization control. », de Lee, Daesu et al., dans Advanced materials, vol. 24(3), 2012, 402-406, doi:10.1002/adma.201103679 décrit une mémoire ferroélectrique de type FeRAM présentant plusieurs niveaux de stockage. Dans cet exemple, comme cela est représenté sur la figure 1 (représentant l'évolution de la polarisation P en fonction de la tension appliquée V), la mémoire peut être placée dans plusieurs états de polarisation rémanente intermédiaires Pr₁, Pr₂, Prs, Pr₄, Pr₅, Pr₆, Pr₇ (Pr₀ correspondant à l'état 0 de polarisation basse). Il va donc être possible de stocker l'information à différents niveaux. Grâce à ce stockage « multi-niveaux », il est donc possible de coder plusieurs états par mémoire (ici, dans l'exemple, huit états sont codés), alors que dans une cellule standard seulement deux états sont accessibles (les états 0 ou 1 uniquement). Ainsi, l'information contenue dans une mémoire avec un stockage « multi-niveaux » est équivalent à celle contenue dans plusieurs mémoires de type standard.

En pratique, dans cet exemple, pour mettre en oeuvre ce stockage sur les différents niveaux intermédiaires, chaque état de polarisation intermédiaire Pr₁, Pr₂, Prs, Pr₄, Pr₅, Pr₆, Pr₇ est associé à un courant correspondant. Ainsi, lors de l'application d'une tension entre les électrodes, un courant ferroélectrique associé est lu. Ce courant permet ensuite d'identifier l'état de polarisation intermédiaire Pr₁, Pr₂, Pr₃, Pr₄, Pr₅, Pr₆, Pr₇ concerné et donc de remonter à l'information stockée initialement dans cet état de polarisation intermédiaire Pr₁, Pr₂, Pr₃, Pr₄, Pr₅, Pr₆, Pr₇ de la mémoire ferroélectrique.

Cependant, certains inconvénients sont observés dans de telles mémoires à haute densité. Il peut par exemple être difficile de distinguer deux états de polarisation intermédiaires qui sont proches. En effet, un recouvrement entre les différents états de polarisation intermédiaires peut être rencontré. Dans un tel cas, l'application d'une tension (entre les électrodes) de cette zone de recouvrement ne permet pas de déduire de manière certaine le courant associé, et donc l'état de polarisation rémanente intermédiaire concerné.

### RÉSUMÉ DE L'INVENTION

La présente invention vise donc à améliorer les dispositifs de stockage ferroélectrique à haute densité en permettant une distinction sans ambiguïté des différents états de polarisation.

L'invention concerne alors un procédé de fabrication d'un dispositif de stockage ferroélectrique comprenant des étapes de :
- fourniture d'une couche support,
- formation d'une cavité dans la couche support, la cavité comprenant une paroi de fond et une paroi latérale, la paroi latérale formant un angle d'inclinaison par rapport à une direction normale à la paroi de fond,
- dépôt d'une première couche dans la cavité,
- dépôt, par une méthode de dépôt physique en phase vapeur, d'une couche de matériau ferroélectrique dans la cavité, la couche de matériau ferroélectrique comprenant une première partie présentant une première épaisseur et une deuxième partie présentant une deuxième épaisseur, la première épaisseur et la deuxième épaisseur étant distinctes,
   le dépôt de la couche de matériau ferroélectrique comprenant des étapes de :
   a) dépôt de la première partie de la couche de matériau ferroélectrique selon une première direction associée à un premier angle de dépôt formé par rapport à une direction normale à la paroi de fond,
   b) dépôt de la deuxième partie de la couche de matériau ferroélectrique selon une deuxième direction associée à un deuxième angle de dépôt formé par rapport à la direction normale à la paroi de fond, le deuxième angle de dépôt et le premier angle de dépôt étant différents, puis
- dépôt d'une deuxième couche dans la cavité, la couche de matériau ferroélectrique s'étendant entre la première couche et la deuxième couche.

Ainsi, d'après le procédé de fabrication conforme à l'invention, la couche de matériau ferroélectrique du dispositif de stockage ferroélectrique présente une épaisseur non uniforme. Cette variabilité d'épaisseurs entraîne une non-uniformité dans les propriétés ferroélectriques du dispositif de stockage ferroélectrique. Cette non-uniformité des propriétés permet notamment d'augmenter les différences entre les gammes de tensions à appliquer pour mémoriser les informations dans les différents états de polarisation intermédiaires.

En effet, les différentes épaisseurs impliquent alors, que pour une tension (d'écriture) donnée, le champ électrique est plus grand dans les régions de plus faible épaisseur. En d'autres termes, pour écrire des informations dans un état de polarisation intermédiaire associé à une faible épaisseur, une plus grande tension doit être appliquée. Les différences d'épaisseurs conduisent donc à des différences de tensions à appliquer pour encoder les informations dans les différents états de polarisation intermédiaires.

Les épaisseurs différentes utilisées sont donc associées à différents états de polarisation intermédiaires dans le dispositif de stockage ferroélectrique.

En d'autres termes, grâce à la non-uniformité créée dans la couche de matériau ferroélectrique (due à la variabilité d'épaisseurs), les différences entre les états de polarisation intermédiaires sont créées.

Outre les caractéristiques qui viennent d'être évoquées dans les paragraphes précédents, le procédé de fabrication du dispositif de stockage ferroélectrique selon un aspect de l'invention peut présenter une ou plusieurs caractéristiques complémentaires parmi les suivantes, considérées individuellement ou selon toutes les combinaisons techniquement possibles :
- le dépôt de la couche de matériau ferroélectrique est mis en oeuvre de manière anisotrope ;
- le dépôt de la couche de matériau ferroélectrique est mis en oeuvre de manière non conforme ;
- le dépôt de la couche de matériau ferroélectrique est mis en oeuvre par une méthode de dépôt par faisceau d'ions ou par une méthode de dépôt par évaporation ;
- le premier angle de dépôt et le deuxième angle de dépôt sont inférieurs à 90 degrés ;
- le dépôt de la première partie de la couche de matériau ferroélectrique est mis en oeuvre par orientation d'un premier faisceau d'ions unidirectionnel selon la première direction et le dépôt de la deuxième partie de la couche de matériau ferroélectrique est mis en oeuvre par orientation d'un deuxième faisceau d'ions unidirectionnel selon la deuxième direction ;
- une modification de l'orientation du premier faisceau d'ions unidirectionnel et/ou du deuxième faisceau d'ions unidirectionnel est réalisée par inclinaison de la couche support ;
- une modification de l'orientation du premier faisceau d'ions unidirectionnel et/ou du deuxième faisceau d'ions unidirectionnel est réalisée par inclinaison d'une cible à partir de laquelle est formé le premier faisceau d'ions unidirectionnel et/ou le deuxième faisceau d'ions unidirectionnel ;
- la couche de matériau ferroélectrique comprend du dioxyde d'hafnium ou du dioxyde d'hafnium dopé par un élément dopant ou un alliage HfₓZr₁₋ₓO₂, avec 0<x<1 ; et
- il est prévu, avant l'étape de dépôt de la deuxième couche, une étape d'implantation d'un élément dopant dans la couche de matériau ferroélectrique de manière à doper la couche de matériau ferroélectrique par l'élément dopant.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
La figure 1 illustre les différents états de polarisation intermédiaires dans le cas d'une mémoire ferroélectrique de type FeRAM présentant plusieurs niveaux de stockage,
La figure 2 représente, sous forme schématique, un exemple d'un dispositif de stockage ferroélectrique conforme à l'invention,
La figure 3 illustre, sous forme schématique, le principe de dépôt d'une couche de matériau ferroélectrique du dispositif de stockage ferroélectrique conforme à l'invention,
La figure 4 représente, sous forme de logigramme, un premier exemple d'un procédé de fabrication du dispositif de stockage ferroélectrique conforme à l'invention,
La figure 5 illustre l'étape E102 du procédé de fabrication représenté sur la figure 4,
La figure 6 illustre l'étape E104 du procédé de fabrication représenté sur la figure 4,
La figure 7 illustre l'étape E106a du procédé de fabrication représenté sur la figure 4,
La figure 8 illustre l'étape E106b du procédé de fabrication représenté sur la figure 4,
La figure 9 illustre l'étape E106c du procédé de fabrication représenté sur la figure 4,
La figure 10 illustre l'étape E108 du procédé de fabrication représenté sur la figure 4,
La figure 11 représente, sous forme de logigramme, un deuxième exemple d'un procédé de fabrication du dispositif de stockage ferroélectrique conforme à l'invention,
La figure 12 illustre l'étape E206b du procédé de fabrication représenté sur la figure 11,
La figure 13 illustre l'étape E206c du procédé de fabrication représenté sur la figure 11, et
La figure 14 illustre l'étape E208 du procédé de fabrication représenté sur la figure 11.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

La présente invention vise à améliorer la fabrication des dispositifs de stockage ferroélectriques. En particulier, la présente invention concerne un dispositif de stockage à haute densité dans lequel plusieurs états de polarisation sont utilisés pour mémoriser les informations. La présente invention vise alors à améliorer la définition des états de polarisation afin d'être en mesure de clairement les distinguer pour pouvoir ensuite lire l'information mémorisée et associée à chacun des états de polarisation.

La figure 2 représente un dispositif 1 de stockage ferroélectrique (également noté dispositif 1 dans la suite) conforme à l'invention. Comme cela est visible sur cette figure, le dispositif 1 de stockage ferroélectrique comprend une première couche 2, une deuxième couche 7 et une couche de matériau ferroélectrique 5 qui disposée entre la première couche 2 et la deuxième couche 7.

Le dispositif 1 de stockage ferroélectrique se présente sous la forme d'un empilement de couches. La première couche 2, la couche de matériau ferroélectrique 5 et la deuxième couche 7 forment les différentes couches de cet empilement.

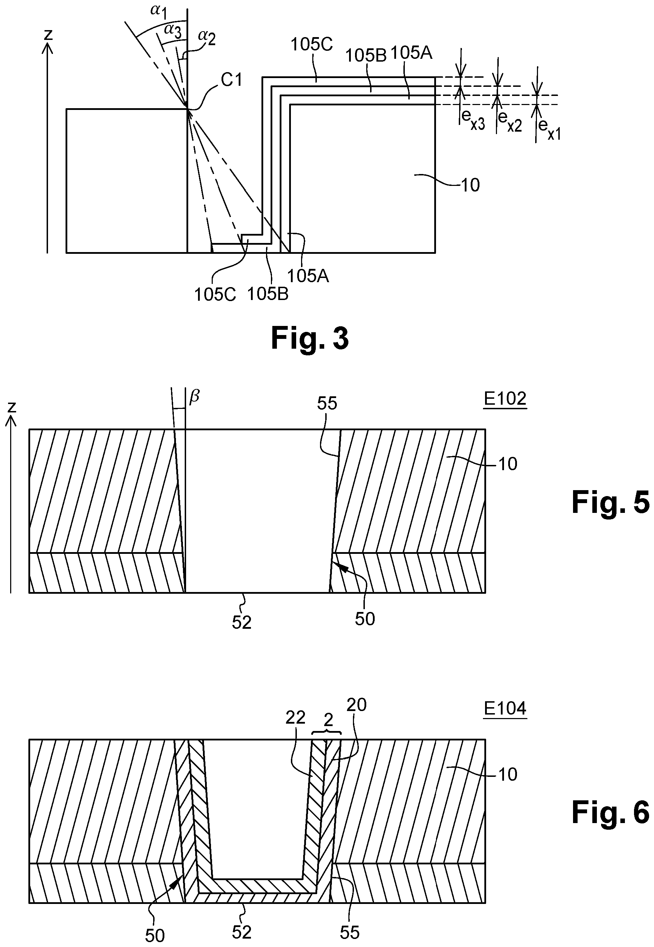

Comme cela sera décrit plus en détails par la suite avec le procédé de fabrication associé, le dispositif 1 de stockage ferroélectrique est formé dans une cavité 50 (visible sur les figures 5 à 10 et les figures 12 à 14).

Cette cavité 50 est par exemple formée dans une couche support 10. En d'autres termes, la cavité 50 forme une partie de la couche support qui présente un profil globalement en forme de « U » (comme cela sera vu par la suite, les branches latérales de la forme en « U » peuvent ici être inclinées par rapport à la base de la forme en « U »). Ici, les différentes couches du dispositif de stockage ferroélectrique 1 présentent un profil de forme similaire à la partie 50 avec un profil en forme de « U » de la couche support 10.

Cette couche support 10 est ici formée d'un matériau diélectrique. Par exemple, la couche support 10 comprend de l'oxyde de silicium SiO₂.

La couche support peut comprendre une pluralité de sous-couches. Par exemple, la couche support peut comprendre une autre couche en matériau diélectrique formée sous la couche comprenant de l'oxyde de silicium SiO₂. Cette autre couche comprend par exemple du nitrure de silicium SiN ou du carbonitrure de silicium SiCN.

La cavité 50 comprend une paroi de fond 52 et une paroi latérale 55. La paroi de fond 52 correspond à la base de la forme en « U » et la paroi latérale 55 correspond aux branches latérales de la forme en « U ». La paroi latérale 55 forme un angle d'inclinaison β par rapport à un axe z, correspondant à une direction normale à la paroi de fond 52. De préférence, cet angle d'inclinaison β est non nul. Cet angle d'inclinaison β est par exemple inférieur à 50 degrés. De préférence, il est par exemple inférieur à 35 degrés. En variante, cet angle d'inclinaison peut être nul (la paroi latérale est donc verticale).

Sur la figure 3, l'angle d'inclinaison de la paroi latérale 55 est sensiblement nul tandis que sur les figures 5 à 10 et les figures 12 à 14, cet angle d'inclinaison β est non nul.

La présente invention trouve une application privilégiée dans le cadre des dispositifs de stockage ferroélectrique formés dans un tel support muni d'une cavité présentant une paroi de fond et une paroi latérale.

L'empilement formant le dispositif 1 de stockage ferroélectrique s'étend à partir de la paroi de fond 52 et de la paroi latérale 55. Cet empilement comprend alors plusieurs parties : une s'étendant depuis la paroi de fond 52 et une autre s'étendant depuis la paroi latérale 55. Pour la partie formée sur la paroi de fond 52, les différentes couches de l'empilement s'étendent parallèlement les unes aux autres. Il en est de même pour la partie s'étendant depuis la paroi latérale 55 (les différentes couches de l'empilement s'étendent également parallèlement les unes aux autres sur cette paroi latérale 55).

En variante, la paroi latérale de la cavité peut comprendre plusieurs portions formant des angles distincts par rapport à une direction normale à la paroi de fond. En d'autres termes, la paroi latérale de la cavité pourrait présenter une pluralité de ruptures de pente.

Chacune des couches formant le dispositif 1 de stockage ferroélectrique est à présent décrite.

La première couche 2 est formée d'un matériau conducteur inerte. Cette première couche 2 comprend par exemple un matériau métallique.

Selon un premier exemple (non représenté), la première couche comprend une unique couche. Le matériau conducteur de cette unique couche comprend par exemple du nitrure de titane TiN. En variante, le matériau conducteur peut être du nitrure de tantale TaN ou du tungstène W. En variante encore, d'autres matériaux conducteurs peuvent être utilisés (et en particulier, du nitrure de métal de manière plus générale).

Comme cela est visible sur l'exemple représenté sur la figure 2, la première couche 2 se présente ici sous la forme d'une structure bicouche. Elle comprend ici une première sous-couche 20 et une deuxième sous-couche 22.

La deuxième sous-couche 22 est disposée sur la première sous-couche 20.

La première sous-couche 20 comprend un matériau conducteur métallique. De préférence, elle comprend du titane Ti ou du nitrure de tantale TaN.

La première sous-couche 20 présente une épaisseur comprise entre 3 et 20 nanomètres (nm). De préférence, cette épaisseur est comprise entre 5 et 10 nm.

Cette première sous-couche 20 joue à la fois le rôle d'une couche de protection, et le rôle d'une couche de contact permettant de raccorder électriquement le dispositif 1 à son circuit électronique de pilotage et de lecture.

La deuxième sous-couche 22 est disposée sur la première sous-couche 20. Elle est en contact direct avec la couche de matériau ferroélectrique 5. En d'autres termes, la deuxième sous-couche 22 s'étend entre la première sous-couche 20 et la couche de matériau ferroélectrique 5.

La deuxième sous-couche 22 est formée d'un matériau conducteur comprenant un métal de transition. Ce matériau conducteur est par exemple du nitrure de titane TiN. En variante, il peut s'agir d'autres matériaux conducteurs tels que du nitrure de tantale TaN ou du tungstène W.

Par exemple, lorsque la deuxième sous-couche 22 comprend du nitrure de titane, la première sous-couche 20est formée d'un matériau conducteur comme le titane Ti.

En variante, lorsque la deuxième sous-couche 22 comprend du tantale, la première sous-couche 20 est formée par exemple de nitrure de tantale TaN.

En variante encore, lorsque la deuxième sous-couche 22 comprend du tungstène, la première sous-couche 20 est formée d'un matériau conducteur en titane Ti.

Ici, l'épaisseur de la deuxième sous-couche 22 est comprise entre 10 et 100 nm. De préférence, cette épaisseur est comprise entre 5 et 10 nm.

En variante, la première couche peut comprendre un matériau semi-conducteur. Ce matériau semi-conducteur comprend par exemple du silicium.

La couche de matériau ferroélectrique 5 est disposée sur la première couche 2. En variante, la couche de matériau ferroélectrique peut être déposée sur une autre couche formée, au préalable, sur la première couche.

Cette couche de matériau ferroélectrique 5 comprend un matériau actif de résistance variable. Cette couche de matériau ferroélectrique 5 est par exemple à base de dioxyde d'hafnium HfO₂. Dans la présente description, on entend par l'expression « à base de » que la couche concernée comprend plus de 50% de l'élément mentionné après cette expression (par exemple ici, cela signifie que la couche de matériau ferroélectrique 5 comprend plus de 50% de dioxyde d'hafnium).

En variante, le dioxyde d'hafnium peut être dopé par un élément dopant. Dans la présente description, l'expression « dopage » d'une couche correspond à l'introduction dans le matériau de la couche concernée des atomes d'un autre matériau appelés « élément dopant ».

Ici, l'élément dopant préférentiellement utilisé est du silicium Si. Dans le cas du silicium, la couche de matériau ferroélectrique à base de dioxyde d'hafnium est par exemple exposée à une dose de dopant comprise entre 1.10¹⁴ cm⁻² et 1.10¹⁵ cm⁻² afin d'obtenir une présence comprise entre 0,7 à 7% d'atomes de silicium dans la couche de matériau ferroélectrique. De préférence, la dose de dopant est comprise entre 0,3.10¹⁵ cm⁻² et 1.10¹⁵ cm⁻².

En variante, d'autres éléments dopants peuvent être utilisés comme de l'aluminium Al, du germanium Ge, du gadolinium Gd, de l'Yttrium Y, du lanthane La, du scandium Sc ou de l'azote N.

En variante encore, la couche de matériau ferroélectrique peut comprendre un alliage de la forme HfₓZr₁₋ₓO₂, avec 0<x<1. Par exemple, il est possible d'utiliser un alliage ternaire HfZrO₂ (par exemple du Hf_{0.5}Zr_{0.5}O₂) en tant que matériau ferroélectrique. En variante encore, la couche de matériau ferroélectrique peut être en nitrure d'aluminium scandium (AlScN).

Comme cela est visible sur les figures 2, 8 et 12, la couche de matériau ferroélectrique 5 comprend au moins une première partie 5A et une deuxième partie 6;6A.

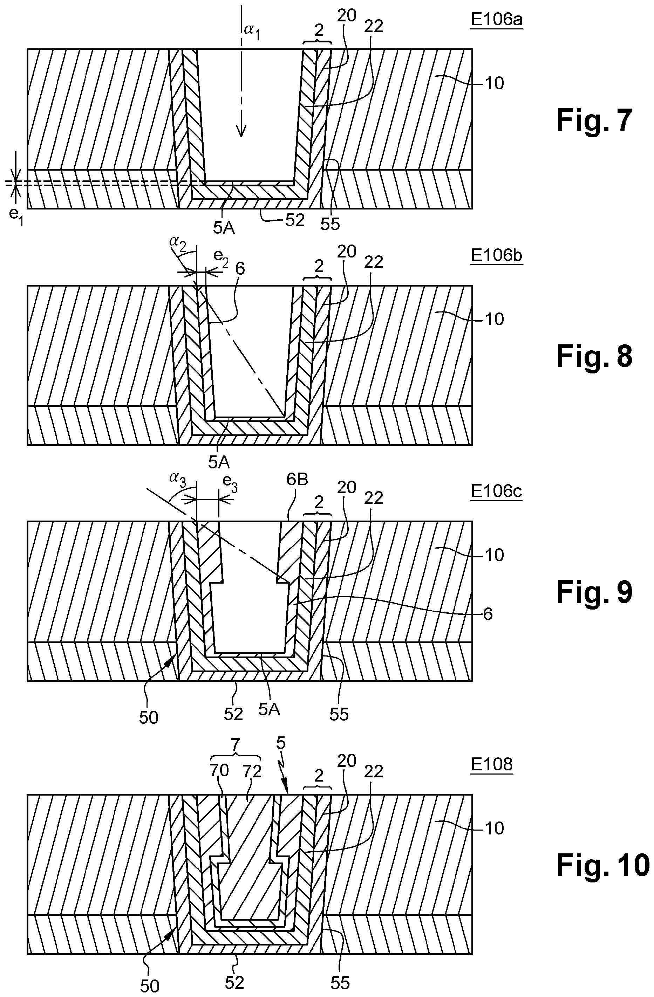

Dans les exemples visibles sur les figures 2 et 8, la première partie 5A s'étend au niveau de la paroi de fond 52 de la cavité 50 tandis que la deuxième partie 6 s'étend au niveau de la paroi latérale 55 de la cavité 50.

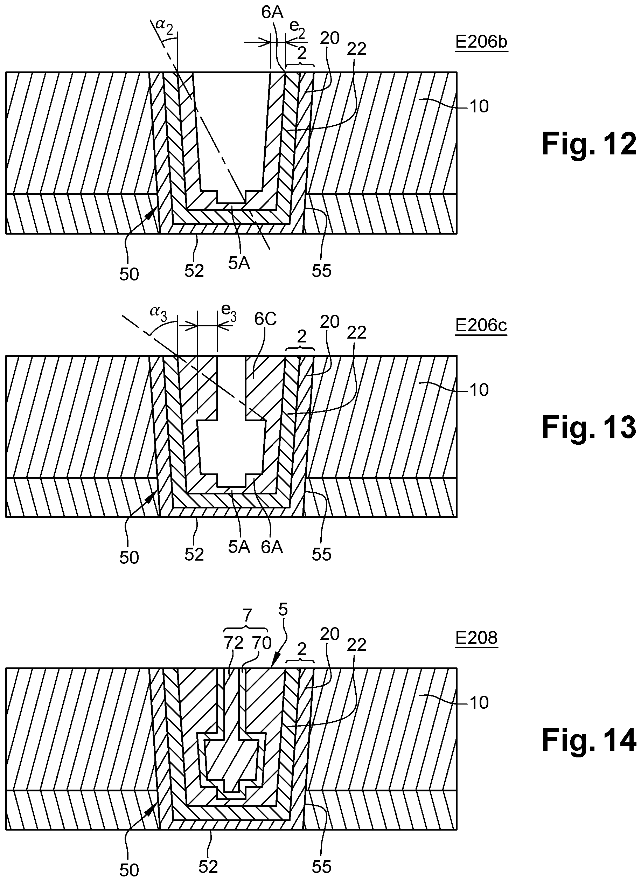

Dans l'exemple représenté sur la figure 12, la première partie 5A s'étend au niveau de la paroi de fond 52 de la cavité 50 et la deuxième partie 6A s'étend au niveau de la paroi latérale 55 de la cavité 50 ainsi qu'en partie au niveau de la paroi de fond 52 (ici sur la première partie 5A).

De manière avantageuse selon l'invention, la première partie 5A présente une première épaisseur e₁ et la deuxième partie 6 ; 6A présente une deuxième épaisseur e₂. Dans la présente invention, on définit l'épaisseur d'une partie d'une couche comme la distance séparant les deux faces de la partie de la couche concernée. En d'autres termes, l'épaisseur correspond à la dimension caractéristique de la couche concernée dans une direction parallèle à une direction normale aux faces de la partie concernée de la couche.

Ici, la première épaisseur e₁ et la deuxième épaisseur e₂ sont distinctes. Autrement dit, la couche de matériau ferroélectrique 5 présente une épaisseur non-uniforme. En d'autres termes encore, la couche de matériau ferroélectrique 5 présente une épaisseur variable.

Les différences d'épaisseurs forment des caractéristiques primordiales du dispositif de stockage ferroélectrique pour obtenir les différents états de polarisation.

Ainsi, grâce à l'invention, les différences d'épaisseurs utilisées pour la couche de matériau ferroélectrique introduisent une non-uniformité dans les propriétés ferroélectriques de la couche de matériau ferroélectrique. Cette non-uniformité des propriétés permet notamment d'augmenter les différences entre les gammes de tensions à appliquer pour encoder les informations dans les différents états de polarisation intermédiaires. Cela permet alors d'éviter le recouvrement entre les gammes de tensions concernées et donc d'identifier sans ambiguïté les états de polarisation intermédiaires concernés par les informations mémorisées.

Afin d'obtenir des états de polarisation bien distincts (i.e. sans recouvrement entre les gammes de tensions à appliquer pour les atteindre), le rapport entre la deuxième épaisseur e₂ et la première épaisseur e₁ est de préférence compris entre 2 et 4.

En pratique, la première épaisseur e₁ est par exemple comprise entre 3 et 7 nm. De préférence, cette première épaisseur e₁ est de l'ordre de 4 nm.

La deuxième épaisseur e₂ est par exemple comprise entre 8 et 17 nm. De préférence, cette deuxième épaisseur e₂ est de l'ordre de 10 nm.

Ici, la deuxième épaisseur e₂ est donc supérieure à la première épaisseur e-i. Cela implique alors qu'il sera nécessaire d'appliquer une plus forte tension pour permettre la mémorisation des informations dans l'état de polarisation intermédiaire associé à la deuxième épaisseur e₂ (en comparaison de la première épaisseur e₁).

Les gammes d'épaisseurs considérées dans l'invention permettent d'accentuer les non-uniformités des propriétés ferroélectriques de la couche de matériau ferroélectrique, de manière à permettre la mémorisation des informations sur différents états de polarisation intermédiaires et à permettre l'encodage de ces informations en distinguant distinctement ces différents états.

Par ailleurs, dans un plan orthogonal à la direction permettant de définir l'épaisseur, on définit une surface de la première partie 5A au niveau de l'une des faces de la couche de matériau ferroélectrique 5. Il est également possible de définir la surface totale de la couche de matériau ferroélectrique 5 comme la surface de l'une des faces de la couche de matériau ferroélectrique 5. Autrement dit, la surface de la première partie 5A correspond à une partie de la surface totale de la couche de matériau ferroélectrique 5.

De manière avantageuse selon l'invention, la première partie 5A présente une surface d'au moins 15% de la surface totale de la couche de matériau ferroélectrique 5. En d'autres termes, la surface de la première partie 5A représente au moins 15% de la surface totale de la couche de matériau ferroélectrique 5.

Ainsi, avantageusement selon l'invention, les non-uniformités (associées aux différences d'épaisseurs) de la couche de matériau ferroélectrique ne sont pas des artefacts de fabrication. Le fait que les parties associées aux différentes épaisseurs présentent des surfaces conséquentes permet de s'assurer d'états de polarisation bien distincts (et donc d'une absence de recouvrement entre mes gammes de tensions à appliquer pour remonter aux différents états de polarisation).

Dans le cas du dispositif de stockage ferroélectrique représenté sur les figures 9 et 13, la couche de matériau ferroélectrique 5 comprend une troisième partie 6B ; 6C. Cette troisième partie 6B : 6C présente une troisième épaisseur es, distincte de la première épaisseur e₁ et de la deuxième épaisseur e₂.

Dans les exemples représentés sur les figures 9 et 13, la troisième partie 6B ; 6C s'étend au niveau de la paroi latérale 55 de la cavité 50.

Cette troisième épaisseur permet d'ajouter une non-uniformité supplémentaire dans les propriétés ferroélectriques de la couche de matériau ferroélectrique 5.

Comme le montrent les figures 2, 10 et 14, la deuxième couche 7 est disposée sur la couche de matériau ferroélectrique 5.

Cette deuxième couche 7 comprend par exemple un matériau conducteur. Il s'agit notamment d'un matériau métallique.

Selon un premier exemple (non représenté), la deuxième couche comprend une unique couche. Le matériau conducteur de cette unique couche comprend par exemple du nitrure de titane TiN. En variante, le matériau conducteur peut être du nitrure de tantale TaN ou du tungstène W. En variante encore, d'autres matériaux conducteurs peuvent être utilisés (et en particulier, du nitrure de métal de manière plus générale).

Comme cela est visible sur les figures 2, 10 et 14, la deuxième couche 7 se présente ici sous la forme d'une structure bicouche. Elle comprend ici une première sous-couche 70 et une deuxième sous-couche 72.

La deuxième sous-couche 72 de la deuxième couche 7 est disposée sur la première sous-couche 70 associée.

La deuxième sous-couche 72 est formée d'un matériau conducteur comprenant un métal de transition. Ce matériau conducteur est par exemple du nitrure de titane TiN. En variante, il peut s'agir d'autres matériaux conducteurs tels que du nitrure de tantale TaN ou du tungstène W.

La deuxième sous-couche 72 présente une épaisseur comprise entre 10 et 200 nm.

Cette deuxième sous-couche 72 joue à la fois le rôle d'une couche de protection, et le rôle d'une couche de contact permettant de raccorder électriquement le dispositif 1 à son circuit électronique de pilotage et de lecture.

La première sous-couche 70 est disposée sur la couche de matériau ferroélectrique 5. Elle est en contact direct avec la couche de matériau ferroélectrique 5. En d'autres termes, la première sous-couche 70 de la deuxième couche 7 s'étend entre la deuxième sous-couche 72 et la couche de matériau ferroélectrique 5.

La deuxième sous-couche 72 comprend un matériau conducteur métallique. De préférence, elle comprend du titane Ti ou du tantale Ta.

Par exemple, lorsque la deuxième sous-couche 72 comprend du nitrure de titane, la première sous-couche 70 est formée d'un matériau conducteur comme le titane Ti.

En variante, lorsque la deuxième sous-couche 72 comprend du nitrure de tantale, la première sous-couche 70 est formée d'un matériau conducteur comme le tantale Ta.

En variante encore, lorsque la deuxième sous-couche 72 comprend du tungstène, la première sous-couche 70 est formée d'un matériau conducteur choisi parmi le titane Ti ou le tantale Ta.

Ici, l'épaisseur de la première sous-couche 70 est comprise entre 3 et 20 nm.

En pratique, dans le cas d'une mémoire de type OxRAM (pour « *Oxide Resistive RAM »),* lorsque cette structure bicouche est utilisée pour la deuxième couche 7, la première sous-couche 70 présente également la particularité d'être une couche qui va permettre la création de lacunes d'oxygène dans la couche de matériau ferroélectrique 5 (lorsque cette première sous-couche 70 est en contact avec la couche de matériau ferroélectrique 5). Dans ce cas, la première sous-couche 70 comprend un matériau conducteur choisi parmi le titane Ti ou le tantale Ta et la deuxième sous-couche 72 comprend un nitrure de titane TiN ou un nitrure de tantale TaN (de manière à former une couche de protection). La création de ces lacunes d'oxygène permet alors d'améliorer les performances du dispositif de stockage ferroélectrique en facilitant les échanges d'oxygène avec la couche de matériau ferroélectrique.

Dans le cas d'une mémoire de type FeRAM, la deuxième couche 7 comprend par exemple un nitrure métallique ou un métal qui ne s'oxyde pas (tel que la tungstène W ou le ruthénium Ru.

Dans le cas d'une mémoire de type FTJ, la structure utilisée est celle d'une mémoire de type FeRAM avec l'introduction d'une couche comprenant un matériau diélectrique entre la couche de matériau ferroélectrique 5 et la deuxième couche 7. Le matériau diélectrique est par exemple un oxyde diélectrique tel que l'oxyde d'aluminium Al₂O₃ ou le dioxyde de silicium SiO₂.

En variante, la deuxième couche peut comprendre un matériau semi-conducteur. Ce matériau semi-conducteur comprend par exemple du silicium.

De manière avantageuse selon l'invention, le dispositif de stockage ferroélectrique comprend une couche de matériau ferroélectrique dont l'épaisseur est variable. Cette variabilité d'épaisseur entraîne une non-uniformité dans les propriétés ferroélectriques du dispositif de stockage ferroélectrique. Cette non-uniformité des propriétés permet notamment d'augmenter les différences entre les gammes de tensions à appliquer pour encoder les informations dans les différents états de polarisation intermédiaires.

En d'autres termes, grâce à la non-uniformité créée dans la couche de matériau ferroélectrique (due à la variabilité d'épaisseurs), les différences entre les états de polarisation intermédiaires sont créées.

En variante, la couche de matériau ferroélectrique peut comprendre plus de trois épaisseurs distinctes. Il peut notamment s'agir d'une variation continue de l'épaisseur.

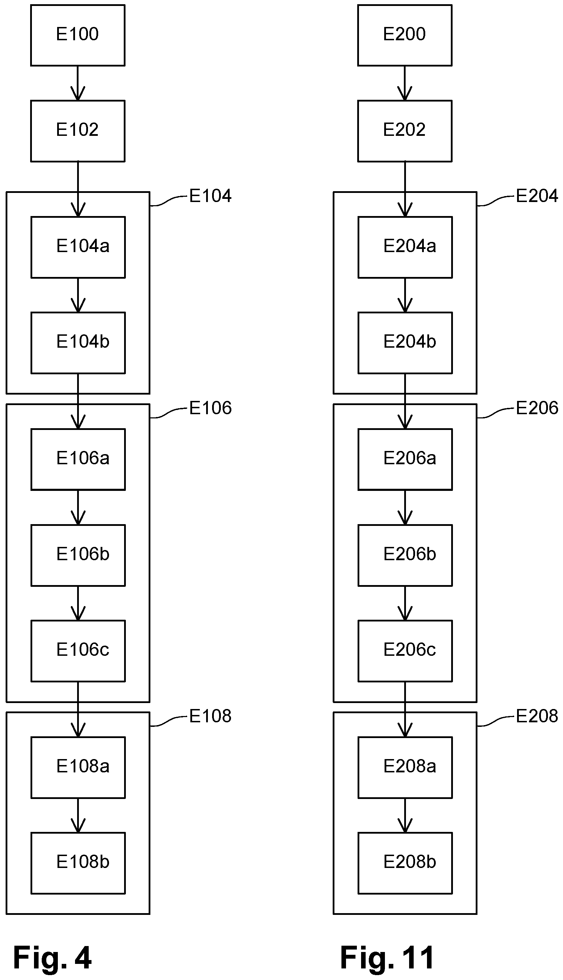

La présente invention concerne également un procédé de fabrication d'un dispositif de stockage ferroélectrique 1. Les figures 4 à 13 concernent ce procédé de fabrication. Plus particulièrement, les figures 4 à 10 concernent un premier exemple de ce procédé de fabrication du dispositif 1 de stockage ferroélectrique selon l'invention. Les figures 11 à 14 concernent un deuxième exemple du procédé de fabrication du dispositif 1 de stockage ferroélectrique.

Le procédé de fabrication du dispositif 1 de stockage ferroélectrique trouve une application privilégiée pour les dispositifs de stockage ferroélectrique formés dans une cavité. La spécificité du procédé de fabrication vise ici à tirer parti du bord de la paroi latérale de la cavité pour former différentes parties de la couche de matériau ferroélectrique avec des épaisseurs différentes.

La figure 4 représente, sous forme de logigramme, un premier exemple du procédé de fabrication.

Comme cela est visible sur cette figure, le procédé de fabrication comprend tout d'abord une étape E100 de fourniture d'une couche support 10 sur laquelle va être formé le dispositif 1 de stockage ferroélectrique. En pratique, cette couche support 10 est munie d'au moins un composant logique associé à un élément d'interconnexion métallique (non représentés) destinés à connecter le dispositif 1 de stockage ferroélectrique à des niveaux métalliques inférieurs.

Puis, le procédé de fabrication se poursuit à l'étape E102, lors de laquelle la cavité 50 (dans laquelle va être formé le dispositif 1 de stockage ferroélectrique) est formée. La figure 4 illustre cette étape E102.

En pratique, cette étape E102 est mise en oeuvre par une gravure anisotrope de manière à former la paroi de fond 52 et la paroi latérale 55 de la cavité 50. Il s'agit par exemple ici d'une gravure chimique sèche.

Comme décrit précédemment, la paroi latérale 55 de la cavité 50 est réalisée de telle manière à former l'angle d'inclinaison β par rapport à l'axe z parallèle à une direction normale à la paroi de fond 52. La paroi latérale 55 forme donc un angle d'inclinaison β par rapport à un axe z, correspondant à une direction normale à la paroi de fond 52.

Comme cela est visible sur la figure 4, le procédé de fabrication se poursuit, à l'étape E104, par le dépôt de la première couche 2. La figure 6 illustre cette étape E104.

Cette première couche 2 est déposée dans la cavité 50. Plus particulièrement, la première couche 2 est déposée le long de la paroi de fond 52 et de la paroi latérale 55 de la cavité 50. La première couche 2 tapisse et épouse donc la forme de la cavité 50.

Le dépôt de la première couche 2 est effectué ici de manière conforme. Dans cette description, on entend par « dépôt conforme » un dépôt mis en oeuvre de telle façon que la couche présente une épaisseur sensiblement constante en tout point. Dans cette description, on entend par « sensiblement constante », une épaisseur ne variant pas de plus de 20 %, de préférence de plus de 10 %, et de préférence encore de plus de 5%. Par exemple, la première couche 2 peut être formée par une méthode de dépôt par couche atomique (ou ALD pour « *Atomic Layer Deposition* » selon l'acronyme d'origine anglo-saxonne couramment utilisé).

Comme indiqué précédemment, la première couche 2 comprend ici une première sous-couche 20 et une deuxième sous-couche 22.

L'étape E104 de dépôt de la première couche 2 comprend donc ici deux sous-étapes : une première sous-étape E104a de dépôt de la première sous-couche 20 et une deuxième sous-étape E104b de dépôt de la deuxième sous-couche 22.

La première sous-couche 20 est donc tout d'abord déposée, de manière conforme, dans la cavité 50 (étape E104a). En pratique, la première sous-couche 20 est par exemple formée par une méthode de dépôt par couche atomique (ou ALD) ou par dépôt chimique en phase vapeur.

En variante, la première sous-couche 20 peut être formée par pulvérisation cathodique dans une chambre de dépôt sous vide. Dans le cas où la première sous-couche 20 est formée en nitrure de titane, il s'agit d'une pulvérisation cathodique réactive.

Puis, la deuxième sous-couche 22 de la première couche 2 est déposée, de manière conforme, sur la première sous-couche 20 (étape E104b). La deuxième sous-couche 22 est par exemple formée par pulvérisation cathodique dans une chambre de dépôt sous vide. En pratique, la deuxième sous-couche 22 de la première couche 2 est formée dans la même chambre de dépôt que la première sous-couche 20 de la première couche 2.

Dans le cas où la deuxième sous-couche 22 est formée en nitrure de titane, il s'agit d'une pulvérisation cathodique réactive.

Puis, le procédé se poursuit à l'étape E106 de dépôt de la couche de matériau ferroélectrique 5 sur la première couche 2. Plus particulièrement, la couche de matériau ferroélectrique 5 est déposée sur la deuxième sous-couche 22 de la première couche 2.

Le dépôt de la couche de matériau ferroélectrique 5 est ici mis en oeuvre de manière anisotrope. Par ailleurs, le dépôt de la couche de matériau ferroélectrique 5 est ici non conforme.

En pratique, la couche de matériau ferroélectrique 5 est déposée par une méthode de dépôt physique en phase vapeur (ou PVD pour « *Physical Vapor Deposition »).*

De préférence ici, la couche de matériau ferroélectrique 5 est déposée par une méthode de dépôt par faisceau d'ions (ou IBD pour « *Ion Beam Deposition* »). En variante, la couche de matériau ferroélectrique peut être déposée par une méthode de dépôt par évaporation sous vide. Il est possible d'obtenir des vitesses de dépôt similaires en utilisant une méthode de dépôt par évaporation sous vide et une méthode de dépôt par faisceau d'ions. En pratique, dans le cas d'une méthode de dépôt par évaporation sous vide, un creuset comprend le matériau à déposer. Ce creuset est chauffé par effet Joule. En faisant varier l'intensité du courant, il est alors possible de faire varier la vitesse de dépôt.

Le caractère anisotrope du dépôt repose ici sur un contrôle de l'orientation d'une cible, à partir de laquelle des atomes sont arrachés, par rapport à un substrat (ici par exemple la couche support). Les atomes arrachés de la cible forment alors un faisceau d'ions associé à une direction de dépôt correspondante. Ainsi, le caractère anisotrope du dépôt est associé à des directions de dépôt différentes (en utilisant les méthodes de dépôt introduites précédemment).

La figure 3 illustre de manière schématique le principe de ce dépôt anisotrope de la couche de matériau ferroélectrique selon l'invention.

Sur cette figure, la cavité 50 est représentée avec une paroi latérale 55 formant un angle nul par rapport à la direction normale (parallèle à l'axe z) à la paroi de fond 52. Bien entendu, le principe décrit ci-après s'applique de la même manière pour les cavités dont la paroi latérale forme un angle non nul avec cette direction normale avec la paroi de fond.

Ici, les différentes épaisseurs de la couche de matériau ferroélectrique sont obtenues en utilisant plusieurs dépôts par faisceau d'ions unidirectionnel orienté chacun selon une direction donnée.

Plus particulièrement, de manière générale, la couche de matériau ferroélectrique est obtenue par le dépôt d'une pluralité de parties (au moins deux) formant, à la fin, cette couche de matériau ferroélectrique 5. Le dépôt de chacune de ces parties est effectué selon un angle de dépôt α₁, α₂, α₃ associé. Chaque angle de dépôt α₁, α₂, α₃ est défini par rapport à une direction normale (parallèle à l'axe z) à la paroi de fond 52 de la cavité 50. Les angles de dépôt α₁, α₂, α₃ sont ici différents les uns des autres. Ici, chaque angle de dépôt α₁, α₂, α₃ est par exemple inférieur à 90 degrés. De préférence, chaque angle de dépôt α₁, α₂, α₃ est compris entre 5 et 85 degrés.

De manière avantageuse selon l'invention, le faisceau d'ions permettant de procéder au dépôt de chacune de ces parties est agencé par rapport au bord de la paroi latérale 55 de la cavité 50. Plus particulièrement ici, chaque faisceau d'ions est agencé par rapport à un coin C1 formé à l'extrémité de la paroi latérale 55 de la cavité 50. Plus particulièrement, le faisceau d'ions concerné est dirigé vers la couche support et est en partie coupé car il croise le coin C1 formé à l'extrémité de la paroi latérale 55 de la cavité 50. Le coin C1 engendre alors un effet d'ombrage en coupant le faisceau d'ions, permettant alors d'exposer uniquement certaines zones de la cavité 50 à ce faisceau d'ions.

En d'autres termes, la paroi latérale 55 de la cavité 50 produit, pour certaines zones de la cavité, un effet d'ombrage, c'est-à-dire que certaines zones de la cavité 50 ne sont pas atteintes par le faisceau d'ions concerné. En d'autres termes, grâce à la configuration des faisceaux d'ions utilisés dans l'invention, chaque faisceau d'ions (à un angle de dépôt associé) entraîne le dépôt du matériau ferroélectrique sur une zone spécifique de la cavité 50.

De plus, les caractéristiques associées à ce faisceau d'ions permettent d'ajuster l'épaisseur de la partie de la couche de matériau ferroélectrique 5 déposée. En particulier, l'épaisseur de chaque partie de la couche de matériau ferroélectrique 5 déposée dépend par exemple ici de la vitesse de dépôt et de temps de dépôt pour former le faisceau d'ions concerné.

De manière avantageuse, l'utilisation de plusieurs angles de dépôt α₁, α₂, α₃ et l'ajustement des paramètres du chaque faisceau d'ions permettent alors d'effectuer des dépôts dans des zones différentes de la cavité 50 mais aussi de faire varier l'épaisseur de la couche de matériau ferroélectrique 5 dans certaines zones de la cavité 50.

Ce principe de dépôt est illustré, de manière schématique, sur la figure 3. Un dépôt d'une première partie 105A de la couche de matériau ferroélectrique 5 est effectué selon un premier angle de dépôt α₁. Comme cela est visible sur la figure 3, selon ce dépôt, la première partie 105A est déposée sur une partie de la paroi de fond 52 et une partie de la paroi latérale 55 de la cavité 50. Ce dépôt de la première partie 105A est mis en oeuvre avec une vitesse de dépôt et pendant une durée de dépôt permettant d'obtenir une épaisseur eₓ₁ pour cette première partie 105A.

Ailleurs dans la cavité 50, comme cela est visible sur la figure 3, les autres zones ne sont pas exposées au faisceau d'ions émis selon le premier angle de dépôt α₁, aucune couche de matériau ferroélectrique n'est donc formée (suite à ce dépôt de la première couche 105A) dans ces zones-là.

Puis, un dépôt d'une deuxième partie 105B de la couche de matériau ferroélectrique 5 est effectué selon un deuxième angle de dépôt α₂. D'après la figure 3, cette deuxième partie 105B est également déposée sur une partie de la paroi de fond 52 et une partie de la paroi latérale 55 de la cavité 50. Plus particulièrement, comme le montre la figure 3, la deuxième partie 105B est, en partie, déposée sur la première couche 105A (ce qui permet pour les zones concernées d'obtenir une épaisseur plus élevée de matériau ferroélectrique).

Ce dépôt de la deuxième partie 105B est mis en oeuvre avec une vitesse de dépôt et pendant une durée de dépôt permettant d'obtenir une épaisseur eₓ₂ pour cette deuxième partie 105B. Ainsi, pour les zones de la cavité 50 déjà munies de la première partie 105A, à ce stade, la couche de matériau ferroélectrique présente une épaisseur de l'ordre de la somme de l'épaisseur eₓ₁ et de l'épaisseur eₓ₂. Pour les autres zones concernées par le dépôt de la deuxième partie 105B, la couche de matériau ferroélectrique présente l'épaisseur eₓ₂.

Ici aussi, les zones non exposées au faisceau d'ions émis selon le deuxième angle de dépôt α₂ sont donc dépourvues de cette deuxième partie 105B (et pour certaines zones, qui n'avaient pas été soumises au faisceau d'ions émis selon le premier angle de dépôt α₁, elles sont, à ce stade, complètement dépourvues de matériau ferroélectrique).

Comme cela est représenté sur la figure 3, le dépôt d'une troisième partie 105C de la couche de matériau ferroélectrique 5 est effectué selon un troisième angle de dépôt α₃. Cette troisième partie 105C est également déposée sur une partie de la paroi de fond 52 et une partie de la paroi latérale 55 de la cavité 50. Plus particulièrement, comme le montre la figure 3, la troisième partie 105C est, en partie, déposée sur la deuxième couche 105B (ce qui permet pour les zones concernées d'obtenir une épaisseur plus élevée de matériau ferroélectrique).

Ce dépôt de la troisième partie 105C est mis en oeuvre avec une vitesse de dépôt et pendant une durée de dépôt permettant d'obtenir une épaisseur eₓ₃ pour cette troisième partie 105C. Ainsi, pour les zones de la cavité 50 déjà munies de la première partie 105A et de la deuxième partie 105B, à ce stade, la couche de matériau ferroélectrique présente une épaisseur de l'ordre de la somme de l'épaisseur eₓ₁, de l'épaisseur eₓ₂ et de l'épaisseur eₓ₃. Pour les zones de la cavité 50 munies de la deuxième partie 105B (uniquement), la couche de matériau ferroélectrique présente (à ce stade) une épaisseur de l'ordre de la somme de l'épaisseur eₓ₂ et de l'épaisseur eₓ₃. Pour les autres zones concernées par le dépôt de la troisième partie 105C, la couche de matériau ferroélectrique présente l'épaisseur eₓ₃.

Ici aussi, les zones non exposées au faisceau d'ions émis selon le troisième angle de dépôt α₃ sont donc dépourvues de cette troisième partie 105C (et pour certaines zones, qui n'avaient pas été soumises au faisceau d'ions émis selon le premier angle de dépôt α₁ ou émis selon le deuxième angle de dépôt α₂, elles sont, à ce stade, complètement dépourvues de matériau ferroélectrique).

L'exemple représenté sur la figure 3 implique l'émission de faisceaux d'ions selon trois angles de dépôt distincts. La présente invention n'est bien entendu pas limitée à trois angles de dépôt. Il peut y en avoir uniquement deux ou plus de trois. D'ailleurs, une généralisation à un nombre plus élevé d'angles de dépôt permet d'obtenir une variation quasi continue de l'épaisseur de la couche de matériau ferroélectrique dans la cavité.

En pratique, le changement d'orientation du faisceau d'ions (i.e. la modification d'angle de dépôt) est mis en oeuvre en positionnant la couche support 10 sur un support de fabrication (non représenté) et en inclinant ce support de fabrication de manière à obtenir l'angle de dépôt recherché.

De plus, afin d'obtenir une symétrie circulaire de dépôt pour chaque partie de la couche de matériau ferroélectrique (et donc pour la couche de matériau ferroélectrique elle-même), le support de fabrication peut être mis en rotation autour d'un axe orthogonal à la paroi de fond 52 de la cavité 50. Cela peut être mis en oeuvre quelle que soit la méthode de dépôt considérée dans la présente invention.

En variante, le changement d'orientation du faisceau d'ions peut être mis en oeuvre en changeant l'orientation de la cible à partir de laquelle les atomes sont arrachés (et qui permettent de former le faisceau d'ions) de manière à obtenir les différents angles de dépôt recherchés.

Sur la base de ce principe de dépôt anisotrope, le procédé de fabrication du dispositif 1 de stockage ferroélectrique comprend alors, à l'étape E106, une étape E106a de dépôt de la première partie 5A de la couche de matériau ferroélectrique 5. Cette étape est représentée sur la figure 7.

Comme décrit précédemment, cette première partie 5A est déposée, dans la cavité 50, selon un premier angle de dépôt α₁. Cette étape E106a est mise en oeuvre de manière à obtenir une épaisseur e₁ de matériau ferroélectrique, pour la première partie 5A, dans la cavité 50.

Ici, la première partie 5A est déposée au niveau de la paroi de fond 52 de la cavité 50. Cela signifie que, dans ce premier exemple de mise en oeuvre du procédé de fabrication selon l'invention, le premier angle de dépôt α₁ est sensiblement nul.

L'étape E106 de dépôt de la couche de matériau ferroélectrique 5 comprend ensuite une étape E106b de dépôt d'une deuxième partie 6 de la couche de matériau ferroélectrique 5. Cette étape E106b est représentée sur la figure 8.

Tel que décrit précédemment, cette deuxième partie 6 est déposée dans la cavité 50, selon un deuxième angle α₂. Cette étape E106b est mise en oeuvre de manière à obtenir une deuxième partie 6 avec une épaisseur e₂ (dans la cavité 50).

Ici, la deuxième partie 6 est déposée au niveau de la paroi latérale 55 de la cavité 50. Le deuxième angle de dépôt α₂ est donc choisi ici en fonction des dimensions de la cavité 50 afin de permettre un dépôt (par faisceau ionique) uniquement sur la paroi latérale 55 de la cavité 50.

Par ailleurs, afin d'assurer une symétrie circulaire du dépôt de cette deuxième partie 6 de la couche de matériau ferroélectrique 5, l'étape E106b comprend par exemple la rotation du support de fabrication (non représenté) afin de s'assurer que la deuxième partie 6 soit déposée sur l'ensemble de la paroi latérale 55 de la cavité 50. Cela peut être mis en oeuvre quelle que soit la méthode de dépôt considérée dans la présente invention.

En variante, cette symétrie circulaire du dépôt peut être assurée par un changement de l'orientation de la cible à partir de laquelle les atomes sont arrachés (et qui permettent de former le faisceau d'ions).

Enfin, comme cela est visible sur la figure 4, l'étape E106 de dépôt de la couche de matériau ferroélectrique 5 comprend ici une étape E106c de dépôt d'une troisième partie 6B de la couche de matériau ferroélectrique 5. Cette étape E106c est représentée sur la figure 9.

Cette deuxième partie 6 est déposée dans la cavité 50 selon un troisième angle α₃. Cette étape E106c est mise en oeuvre de manière à obtenir une troisième partie 6B avec une épaisseur e₃ (dans la cavité 50).

Ici, la troisième partie 6B est déposée au niveau de la paroi latérale 55 de la cavité 50 (et même ici au niveau de l'extrémité de la paroi latérale 55, à l'opposé de la paroi de fond 52 de la cavité 50). Le troisième angle de dépôt α₃ est donc choisi ici afin de permettre un dépôt (par faisceau ionique) uniquement sur la zone concernée de la paroi latérale 55 de la cavité 50.

Par ailleurs, afin d'assurer, ici aussi, une symétrie circulaire du dépôt de cette troisième partie 6B de la couche de matériau ferroélectrique 5, l'étape E106c comprend par exemple la rotation du support de fabrication (non représenté) afin de s'assurer que la troisième partie 6B soit déposée sur la zone concernée de la paroi latérale 55 de la cavité 50. Cela peut être mis en oeuvre quelle que soit la méthode de dépôt considérée dans la présente invention.

En variante, cette symétrie circulaire du dépôt peut être assurée par un changement de l'orientation de la cible à partir de laquelle les atomes sont arrachés (et qui permettent de former le faisceau d'ions).

Finalement, à l'issue de l'étape E106, la couche de matériau ferroélectrique 5 est formée dans la cavité 50. Dans ce premier exemple du procédé de fabrication du dispositif 1 de matériau ferroélectrique, la couche de matériau ferroélectrique 5 comprend ici la première partie 5A d'épaisseur e₁ formée sur la paroi de fond 52 de la cavité 50, la deuxième partie 6 d'épaisseur e₂ formée sur la paroi latérale 55 de la cavité 50 et la troisième partie 6B d'épaisseur es formée sur une partie de la paroi latérale 55 de la cavité 50.

Les épaisseurs e₁, e₂, es sont ici distinctes. Cela implique alors qu'il sera nécessaire d'appliquer des tensions différentes pour permettre la lecture des informations mémorisées dans l'état de polarisation intermédiaire associé à chacune de la première partie 5A, de la deuxième partie 6 et de la troisième partie 6B.

Il est à noter ici que l'étape E106c peut être omise s'il est souhaité que la couche de matériau ferroélectrique comprenne uniquement deux épaisseurs différentes. Bien entendu, l'étape E106 peut comprendre des étapes supplémentaires correspondant au dépôt de parties supplémentaires de la couche de matériau ferroélectrique présentant d'autres épaisseurs (ces dépôts étant mis en oeuvre selon d'autres angles de dépôt par exemple).

Le procédé se poursuit ensuite, à l'étape E108, par le dépôt de la deuxième couche 7. Cette étape E108 est représentée sur la figure 10.

La deuxième couche 7 est formée sur la couche de matériau ferroélectrique 5 obtenue à l'issue de l'étape E106.

Le dépôt de la deuxième couche 7 est réalisé de manière conforme.

Comme indiqué précédemment, la deuxième couche 7 peut comprendre ici une première sous-couche 70 et une deuxième sous-couche 72.

L'étape E108 de dépôt de la deuxième couche 7 comprend donc ici deux sous-étapes : une première sous-étape E108a de dépôt de la première sous-couche 70 et une deuxième sous-étape 108b de dépôt de la deuxième sous-couche 72.

La première sous-couche 70 est donc tout d'abord déposée, de manière conforme, sur la couche de matériau ferroélectrique 5 (étape E108a). En pratique, la première sous-couche 70 est par exemple formée par pulvérisation cathodique dans une chambre de dépôt sous vide. Dans le cas où la première sous-couche 70 est formée en nitrure de titane, il s'agit d'une pulvérisation cathodique réactive.

En variante, la première sous-couche peut être formée par un dépôt chimique en phase vapeur.

Puis, la deuxième sous-couche 72 de la deuxième couche 7 est déposée, de manière conforme, sur la première sous-couche 70 (étape E108b). Comme cela est visible sur la figure 10, la deuxième sous-couche 72 est formée de manière à remplir tout l'espace restant dans la cavité 50. Cela permet alors d'obtenir un dispositif de stockage ferroélectrique 1 complètement intégré dans la cavité 50 et sans saillie ou récession formée par rapport à la surface de la couche support 10. L'ensemble formé par la couche support 10 dans laquelle est intégrée le dispositif de stockage ferroélectrique 1 présente donc une surface uniforme.

En pratique, la deuxième sous-couche 72 est par exemple formée par pulvérisation cathodique dans une chambre de dépôt sous vide. En pratique, la deuxième sous-couche 72 de la deuxième couche 7 est formée dans la même chambre de dépôt que la première sous-couche 70 de la deuxième couche 7.

Dans le cas où la deuxième sous-couche 72 est formée en nitrure de titane, il s'agit d'une pulvérisation cathodique réactive.

En pratique, en bien que cela ne soit pas visible sur les figures annexées, il n'est pas exclu que les différentes couches du dispositif 1 de stockage ferroélectrique soient déposées également sur la face avant (surface libre à l'opposé de la paroi de fond 52) de la couche support 10. Ainsi, de manière optionnelle, afin de s'assurer de la planéité et de l'uniformité du dispositif 1 de stockage ferroélectrique (et en particulier de la surface libre du dispositif 1), il peut être prévu une étape de planarisation, après l'étape E108. Cette étape de planarisation est par exemple mise en oeuvre par polissage mécanochimique (ou CMP pour « *Chemical mechanical polishing »* selon l'acronyme d'origine anglosaxonne couramment utilisé). Tout autre méthode adaptée peut être utilisée (notamment les méthodes de masquage).

Cette étape de planarisation est particulièrement avantageuse car, grâce à l'uniformisation de la surface du dispositif 1, elle permet d'améliorer les performances électriques du dispositif de stockage ferroélectrique et de garantir une meilleure qualité des interconnexions.

En variante, une étape d'encapsulation peut être prévue après cette étape de planarisation. Enfin, un raccordement à la deuxième couche 7 peut être mis en oeuvre.

Ainsi, à l'issue du procédé de fabrication selon ce premier exemple, le dispositif 1 de stockage ferroélectrique obtenu comprend une couche de matériau ferroélectrique 5 à épaisseur variable. Ici, cette variabilité d'épaisseurs est obtenue en jouant sur la différence d'uniformité du dépôt entre la paroi de fond et la paroi latérale de la cavité. Plus particulièrement, les différences d'épaisseurs sont obtenues en choisissant des conditions optimales pour le dépôt du matériau ferroélectrique par un judicieux contrôle de l'inclinaison de flux d'atomes utilisés pour ce dépôt.

Comme indiqué précédemment, la variabilité d'épaisseurs permet d'introduire des non-uniformités dans les propriétés ferroélectriques de la couche de matériau ferroélectrique. Cette non-uniformité des propriétés permet notamment d'augmenter les différences entre les gammes de tensions à appliquer pour accéder aux différents états de polarisation intermédiaires.

Cela permet alors d'éviter le recouvrement entre les gammes de tensions concernées et donc d'identifier sans ambiguïté les états de polarisation intermédiaires concernés par les informations lues.

De plus, le procédé de fabrication selon ce premier exemple permet d'obtenir une architecture du dispositif 1 de stockage ferroélectrique en trois dimensions. Cela permet notamment d'augmenter la surface de la capacité du dispositif 1 de stockage ferroélectrique.

Selon une variante de mise en oeuvre de ce premier exemple, le procédé de fabrication peut comprendre, entre l'étape E106 de dépôt de la couche de matériau ferroélectrique et l'étape E108 de dépôt de la deuxième couche, une étape d'implantation d'un élément dopant dans la couche de matériau ferroélectrique formée à l'étape E106. Cette étape permet alors de doper la couche de matériau ferroélectrique par l'élément dopant.

En pratique, l'étape d'implantation est par exemple mise en oeuvre dans un réacteur différent de la chambre de dépôt de la première couche et de la couche de matériau ferroélectrique.

Ici, il s'agit par exemple d'une étape d'implantation ionique du silicium (qui est l'élément dopant) dans la couche de matériau ferroélectrique. Les doses d'implantation sont par exemple comprises entre 1.10¹⁴ cm⁻² et 1.10¹⁵ cm⁻². De préférence, la dose d'implantation est comprise entre 0,3.10¹⁵ cm⁻² et 1.10¹⁵ cm⁻².

La figure 11 représente, sous forme de logigramme, un deuxième exemple du procédé de fabrication conforme à l'invention.

Ce deuxième exemple du procédé de fabrication est similaire au premier exemple décrit précédemment. Aussi seules les différences par rapport à ce premier exemple sont décrites en détails dans la suite.

Comme cela est visible sur la figure 11, le procédé de fabrication comprend tout d'abord une étape E200 (similaire à l'étape E100) de fourniture d'une couche support 10 sur laquelle va être formé le dispositif 1 de stockage ferroélectrique. En pratique, cette couche support 10 est munie d'au moins un composant logique associé à un élément d'interconnexion métallique (non représentés) destinés à connecter le dispositif 1 de stockage ferroélectrique à des niveaux métalliques inférieurs.

Puis, le procédé de fabrication se poursuit à l'étape E202 (similaire à l'étape E102 décrite précédemment), lors de laquelle la cavité 50 (dans laquelle va être formé le dispositif 1 de stockage ferroélectrique) est formée.

En pratique, cette étape E202 est mise en oeuvre par une gravure isotrope de manière à former la paroi de fond 52 et la paroi latérale 55 de la cavité 50. Il s'agit par exemple ici d'une gravure chimique sèche.

Comme décrit précédemment, la paroi latérale 55 de la cavité 50 est réalisée de telle manière à former l'angle d'inclinaison β par rapport à l'axe z parallèle à une direction normale à la paroi de fond 52.

Comme cela est visible sur la figure 11, le procédé de fabrication selon ce deuxième exemple se poursuit à l'étape E204, par le dépôt de la première couche 2. L'étape E204 est similaire à l'étape E104 décrite pour le premier exemple.

Cette première couche 2 est déposée dans la cavité 50. Plus particulièrement, la première couche 2 est déposée le long de la paroi de fond 52 et de la paroi latérale 55 de la cavité 50. La première couche 2 tapisse et épouse donc la forme de la cavité 50.

Comme indiqué précédemment, la première couche 2 comprend ici une première sous-couche 20 et une deuxième sous-couche 22.

L'étape E204 de dépôt de la première couche 2 comprend donc ici deux sous-étapes : une première sous-étape E204a de dépôt de la première sous-couche 20 et une deuxième sous-étape E204b de dépôt de la deuxième sous-couche 22.

La première sous-couche 20 est donc tout d'abord déposée, de manière conforme, dans la cavité 50 (étape E204a). En pratique, la première sous-couche 20 est par exemple formée par une méthode de dépôt par couche atomique (ou ALD) ou par dépôt chimique en phase vapeur.

En variante, la première sous-couche 20 peut être formée par pulvérisation cathodique dans une chambre de dépôt sous vide. Dans le cas où la première sous-couche 20 est formée en nitrure de titane, il s'agit d'une pulvérisation cathodique réactive.

Puis, la deuxième sous-couche 22 de la première couche 2 est déposée, de manière conforme, sur la première sous-couche 20 (étape E204b). La deuxième sous-couche 22 est par exemple formée par pulvérisation cathodique dans une chambre de dépôt sous vide. En pratique, la deuxième sous-couche 22 de la première couche 2 est formée dans la même chambre de dépôt que la première sous-couche 20 de la première couche 2.

Dans le cas où la deuxième sous-couche 22 est formée en nitrure de titane, il s'agit d'une pulvérisation cathodique réactive.

Puis, le procédé se poursuit à l'étape E206 de dépôt de la couche de matériau ferroélectrique 5 sur la première couche 2. Plus particulièrement, la couche de matériau ferroélectrique 5 est déposée sur la deuxième sous-couche 22 de la première couche 2.

Le dépôt de la couche de matériau ferroélectrique 5 est, ici aussi, mis en oeuvre de manière anisotrope. Par ailleurs, le dépôt de la couche de matériau ferroélectrique 5 est ici non conforme.

En pratique, la couche de matériau ferroélectrique 5 est déposée par une méthode de dépôt physique en phase vapeur (ou PVD pour « *Physical Vapor Déposition »).*

De préférence ici, la couche de matériau ferroélectrique 5 est déposée par une méthode de dépôt par faisceau d'ions (ou IBD pour « *Ion Beam Deposition* »). En variante, la couche de matériau ferroélectrique peut être déposée par une méthode de dépôt par évaporation sous vide. Il est possible d'obtenir des vitesses de dépôt similaires en utilisant une méthode de dépôt par évaporation sous vide et une méthode de dépôt par faisceau d'ions. En pratique, dans le cas d'une méthode de dépôt par évaporation sous vide, un creuset comprend le matériau à déposer. Ce creuset est chauffé par effet Joule. En faisant varier l'intensité du courant, il est alors possible de faire varier la vitesse de dépôt.

Le caractère anisotrope du dépôt repose également ici sur un contrôle de l'orientation d'une cible, à partir de laquelle des atomes sont arrachés, par rapport à un substrat (ici par exemple la couche support). Les atomes arrachés de la cible forment alors un faisceau d'ions associé à une direction de dépôt correspondante. Ainsi, le caractère anisotrope du dépôt est associé à des directions de dépôt différentes (en utilisant les méthodes de dépôt introduites précédemment).

Sur la base de ce principe de dépôt anisotrope, le procédé de fabrication du dispositif 1 de stockage ferroélectrique comprend alors, à l'étape E206, une étape E206a (similaire à l'étape E106a décrite précédemment) de dépôt de la première partie 5A de la couche de matériau ferroélectrique 5.

Comme décrit précédemment, cette première partie 5A est déposée, dans la cavité 50, selon un premier angle de dépôt α₁. Cette étape E206a est mise en oeuvre de manière à obtenir une épaisseur e₁ de matériau ferroélectrique, pour la première partie 5A, dans la cavité 50.

Ici, la première partie 5A est déposée au niveau de la paroi de fond 52 de la cavité 50. Cela signifie que, dans ce deuxième exemple de mise en oeuvre du procédé de fabrication selon l'invention, le premier angle de dépôt α₁ est sensiblement nul.

L'étape E206 de dépôt de la couche de matériau ferroélectrique 5 comprend ensuite une étape E206b de dépôt d'une deuxième partie 6A de la couche de matériau ferroélectrique 5. Cette étape E206B est représentée sur la figure 12.

Tel que décrit précédemment, cette deuxième partie 6A est déposée dans la cavité 50, selon un deuxième angle α₂. Cette étape E206b est mise en oeuvre de manière à obtenir une deuxième partie 6A présentant une épaisseur e₂ (dans la cavité 50).

Ici, la deuxième partie 6A est déposée au niveau de la paroi latérale 55 de la cavité 50 et d'une partie de la paroi de fond 52 de la cavité 50. Le deuxième angle de dépôt α₂ est donc choisi ici afin de permettre un dépôt (par faisceau ionique) sur la paroi latérale 55 et au niveau d'une partie de la paroi de fond de la cavité 50.

Par ailleurs, afin d'assurer une symétrie circulaire du dépôt de cette deuxième partie 6A de la couche de matériau ferroélectrique 5, l'étape E206b comprend par exemple la rotation du support de fabrication (non représenté) afin de s'assurer que la deuxième partie 6A soit déposée sur l'ensemble de la paroi latérale 55 et sur la partie concernée de la paroi de fond 52 de la cavité 50. Cela peut être mis en oeuvre quelle que soit la méthode de dépôt considérée dans la présente invention.

En variante, cette symétrie circulaire du dépôt peut être assurée par un changement de l'orientation de la cible à partir de laquelle les atomes sont arrachés (et qui permettent de former le faisceau d'ions).

Enfin, comme cela est visible sur la figure 11, l'étape E206 de dépôt de la couche de matériau ferroélectrique 5 comprend ici une étape E206c (similaire à l'étape E106c décrite précédemment) de dépôt d'une troisième partie 6C de la couche de matériau ferroélectrique 5. Cette étape E206c est représentée sur la figure 13.

Cette troisième partie 6C est déposée dans la cavité 50 selon un troisième angle α₃. Cette étape E206c est mise en oeuvre de manière à obtenir une troisième partie 6C avec une épaisseur e₃ (dans la cavité 50).

Ici, la troisième partie 6C est déposée au niveau de la paroi latérale 55 de la cavité 50 (et même ici au niveau de l'extrémité de la paroi latérale 55, à l'opposé de la paroi de fond 52 de la cavité 50). Le troisième angle de dépôt α₃ est donc choisi ici afin de permettre un dépôt (par faisceau ionique) uniquement sur la zone concernée de la paroi latérale 55 de la cavité 50.

Par ailleurs, afin d'assurer, ici aussi, une symétrie circulaire du dépôt de cette troisième partie 6C de la couche de matériau ferroélectrique 5, l'étape E206c comprend par exemple la rotation du support de fabrication (non représenté) afin de s'assurer que la troisième partie 6C soit déposée sur la zone concernée de la paroi latérale 55 de la cavité 50. Cela peut être mis en oeuvre quelle que soit la méthode de dépôt considérée dans la présente invention.

En variante, cette symétrie circulaire du dépôt peut être assurée par un changement de l'orientation de la cible à partir de laquelle les atomes sont arrachés (et qui permettent de former le faisceau d'ions).

Finalement, à l'issue de l'étape E206, la couche de matériau ferroélectrique 5 est formée dans la cavité 50. Dans le deuxième exemple du procédé de fabrication du dispositif 1 de matériau ferroélectrique, la couche de matériau ferroélectrique 5 comprend ici la première partie 5A d'épaisseur e₁ formée sur la paroi de fond 52 de la cavité 50, la deuxième partie 6A d'épaisseur e₂ formée sur la paroi latérale 55 et sur une partie de la paroi de fond de la cavité 50 et la troisième partie 6C d'épaisseur es formée sur une partie de la paroi latérale 55 de la cavité 50.

Les épaisseurs e₁, e₂, es sont ici distinctes. Cela implique alors qu'il sera nécessaire d'appliquer des tensions différentes pour permettre la lecture des informations mémorisées dans l'état de polarisation intermédiaire associé à chacune de la première partie 5A, de la deuxième partie 6A et de la troisième partie 6C.

Il est à noter ici que l'étape E206c peut être omise s'il est souhaité que la couche de matériau ferroélectrique comprenne uniquement deux épaisseurs différentes. Bien entendu, l'étape E206 (comme pour l'étape E106 décrite précédemment) peut comprendre des étapes supplémentaires correspondant au dépôt de parties supplémentaires de la couche de matériau ferroélectrique à d'autres épaisseurs (ces dépôts étant mis en oeuvre selon d'autres angles de dépôt).

Le procédé se poursuit ensuite, à l'étape E208, par le dépôt de la deuxième couche 7. Cette étape E208 est représentée sur la figure 14. Cette étape est similaire à l'étape E108 décrite précédemment pour le premier exemple.

La deuxième couche 7 est formée sur la couche de matériau ferroélectrique 5 obtenue à l'issue de l'étape E206.

Le dépôt de la deuxième couche 7 est réalisé de manière conforme.

Comme indiqué précédemment, la deuxième couche 7 peut comprendre ici une première sous-couche 70 et une deuxième sous-couche 72.

L'étape E208 de dépôt de la deuxième couche 7 comprend donc ici deux sous-étapes : une première sous-étape E208a de dépôt de la première sous-couche 70 et une deuxième sous-étape E208b de dépôt de la deuxième sous-couche 72.

La première sous-couche 70 est donc tout d'abord déposée, de manière conforme, sur la couche de matériau ferroélectrique 5 (étape E208a). En pratique, la première sous-couche 70 est par exemple formée par pulvérisation cathodique dans une chambre de dépôt sous vide. Dans le cas où la première sous-couche 70 est formée en nitrure de titane, il s'agit d'une pulvérisation cathodique réactive.

En variante, la première sous-couche peut être formée par un dépôt chimique en phase vapeur.

Puis, la deuxième sous-couche 72 de la deuxième couche 7 est déposée, de manière conforme, sur la première sous-couche 70 (étape E208b). Comme cela est visible sur la figure 14, la deuxième sous-couche 72 est formée de manière à remplir tout l'espace restant dans la cavité 50. Cela permet alors d'obtenir un dispositif 1 de stockage ferroélectrique complètement intégré dans la cavité 50 et sans saillie ou récession formée par rapport à la surface de la couche support 10. L'ensemble formé par la couche support 10 dans laquelle est intégrée le dispositif 1 de stockage ferroélectrique présente donc une surface uniforme.

En pratique, la deuxième sous-couche 72 est par exemple formée par pulvérisation cathodique dans une chambre de dépôt sous vide. En pratique, la deuxième sous-couche 72 de la deuxième couche 7 est formée dans la même chambre de dépôt que la première sous-couche 70 de la deuxième couche 7.

Dans le cas où la deuxième sous-couche 72 est formée en nitrure de titane, il s'agit d'une pulvérisation cathodique réactive.

En pratique, en bien que cela ne soit pas visible sur les figures annexées, il n'est pas exclu que les différentes couches du dispositif 1 de stockage ferroélectrique soient déposées également sur la face avant (surface libre à l'opposé de la paroi de fond 52) de la couche support 10. Ainsi, de manière optionnelle, afin de s'assurer de la planéité et de l'uniformité du dispositif 1 de stockage ferroélectrique (et en particulier de la surface libre du dispositif 1), il peut être également prévu une étape de planarisation, après l'étape E208. Cette étape de planarisation est par exemple mise en oeuvre par polissage mécanochimique (ou CMP pour « *Chemical mechanical polishing* » selon l'acronyme d'origine anglosaxonne couramment utilisé). Tout autre méthode adaptée peut être utilisée (notamment les méthodes de masquage).

Cette étape de planarisation est particulièrement avantageuse car, grâce à l'uniformisation de la surface du dispositif 1, elle permet d'améliorer les performances électriques du dispositif de stockage ferroélectrique et de garantir une meilleure qualité des interconnexions.

En variante, une étape d'encapsulation peut être prévue après cette étape de planarisation. Enfin, un raccordement à la deuxième couche 7 peut être mis en oeuvre.

Ainsi, à l'issue du procédé de fabrication selon ce deuxième exemple, le dispositif 1 de stockage ferroélectrique obtenu comprend une couche de matériau ferroélectrique à épaisseur variable. Ici, cette variabilité d'épaisseurs est obtenue en jouant sur la différence d'uniformité du dépôt entre la paroi de fond et la paroi latérale de la cavité. Plus particulièrement, les différences d'épaisseurs sont obtenues en choisissant des conditions optimales pour le dépôt du matériau ferroélectrique par un judicieux contrôle de l'inclinaison de flux d'atomes utilisés pour ce dépôt.

Comme indiqué précédemment, cette variabilité d'épaisseurs permet d'introduire une non-uniformité dans les propriétés ferroélectriques de la couche de matériau ferroélectrique. Cette non-uniformité des propriétés permet notamment d'augmenter les différences entre les gammes de tensions à appliquer pour accéder aux différents états de polarisation intermédiaires. Cela permet alors d'éviter le recouvrement entre les gammes de tensions concernées et donc d'identifier sans ambiguïté les états de polarisation intermédiaires concernés par les informations lues.

De plus, le procédé de fabrication selon ce deuxième exemple permet également d'obtenir une architecture du dispositif 1 de stockage ferroélectrique en trois dimensions. Cela permet notamment d'augmenter la surface de la capacité du dispositif 1 de stockage ferroélectrique.

Selon une variante de mise en oeuvre de ce deuxième exemple, le procédé de fabrication peut comprendre, entre l'étape E206 de dépôt de la couche de matériau ferroélectrique et l'étape E208 de dépôt de la deuxième couche, une étape d'implantation d'un élément dopant dans la couche de matériau ferroélectrique formée à l'étape E206. Cette étape permet alors de doper la couche de matériau ferroélectrique par l'élément dopant.

En pratique, l'étape d'implantation est par exemple mise en oeuvre dans un réacteur différent de la chambre de dépôt de la première couche et de la couche de matériau ferroélectrique.

Ici, il s'agit par exemple d'une étape d'implantation ionique du silicium (qui est l'élément dopant) dans la couche de matériau ferroélectrique. Les doses d'implantation sont par exemple comprises entre 1.10¹⁴ cm⁻² et 1.10¹⁵ cm⁻². De préférence, la dose d'implantation est comprise entre 0,3.10¹⁵ cm⁻² et 1.10¹⁵ cm⁻².

### Applications

Le dispositif de stockage ferroélectrique conforme à l'invention trouve une application privilégiée dans le cadre des mémoires résistives de type FeRAM (pour *« Ferroelectric Random Access Memory* » selon l'acronyme d'origine anglo-saxonne couramment utilisé).

Il trouve également une application particulière dans le cadre de transistors, par exemple de type FeMFET (pour « *Ferroelectric-metal field effect transistor »* selon l'acronyme d'origine anglo-saxonne couramment utilisé).

Le dispositif de stockage ferroélectrique conforme à l'invention peut également être utilisé dans le cadre de jonctions tunnel ferroélectriques (ou FTJ pour *« Ferroelectric tunnel jonction* » selon l'acronyme d'origine anglosaxonne couramment utilisé). Dans ce cas, une couche supplémentaire est ajoutée entre la couche de matériau ferroélectrique et la deuxième couche. Cette couche supplémentaire comprend un matériau diélectrique. Ce matériau diélectrique est par exemple un oxyde d'aluminium Al₂O₃.

Dans le cas de certaines applications mentionnées (par exemple les mémoires de type FeRAM ou de type FTJ), la première couche forme une première électrode (par exemple une électrode inférieure), la deuxième couche forme une deuxième électrode (par exemple une électrode supérieure) et la couche de matériau ferroélectrique forme une couche mémoire.

## Revendications

1. Procédé de fabrication d'un dispositif (1) de stockage ferroélectrique comprenant des étapes de :
- fourniture d'une couche support (10),
- formation d'une cavité (50) dans la couche support (10), la cavité (50) comprenant une paroi de fond (52) et une paroi latérale (55), la paroi latérale (55) formant un angle d'inclinaison (β) par rapport à une direction normale à la paroi de fond (52),
- dépôt d'une première couche (2) dans la cavité (50),
- dépôt, par une méthode de dépôt physique en phase vapeur, d'une couche de matériau ferroélectrique (5) dans la cavité (50), la couche de matériau ferroélectrique (5) comprenant une première partie (5A) présentant une première épaisseur (e₁) et une deuxième partie (6 ; 6A) présentant une deuxième épaisseur (e₂), la première épaisseur (e₁) et la deuxième épaisseur (e₂) étant distinctes,
le dépôt de la couche de matériau ferroélectrique (5) comprenant des étapes de :
a) dépôt de la première partie (5A) de la couche de matériau ferroélectrique (5) selon une première direction associée à un premier angle de dépôt (α₁) formé par rapport à une direction normale à la paroi de fond (52),
b) dépôt de la deuxième partie (6 ; 6A) de la couche de matériau ferroélectrique (5) selon une deuxième direction associée à un deuxième angle de dépôt (α₂) formé par rapport à la direction normale à la paroi de fond (52), le deuxième angle de dépôt (α₂) et le premier angle de dépôt (α₁) étant différents, puis
- dépôt d'une deuxième couche (7) dans la cavité (50), la couche de matériau ferroélectrique (5) s'étendant entre la première couche (2) et la deuxième couche (7).

2. Procédé de fabrication selon la revendication 1, dans lequel le dépôt de la couche de matériau ferroélectrique (5) est mis en oeuvre de manière anisotrope.

3. Procédé de fabrication selon la revendication 1 ou 2, dans lequel le dépôt de la couche de matériau ferroélectrique (5) est mis en oeuvre de manière non conforme.

4. Procédé de fabrication selon l'une quelconque des revendications 1 à 3, dans lequel le dépôt de la couche de matériau ferroélectrique (5) est mis en oeuvre par une méthode de dépôt par faisceau d'ions ou par une méthode de dépôt par évaporation.

5. Procédé de fabrication selon l'une quelconque des revendications 1 à 4, dans lequel le premier angle de dépôt (α₁) et le deuxième angle de dépôt (α₂) sont inférieurs à 90 degrés.

6. Procédé de fabrication selon l'une quelconque des revendications 1 à 5, dans lequel le dépôt de la première partie (5A) de la couche de matériau ferroélectrique (5) est mis en oeuvre par orientation d'un premier faisceau d'ions unidirectionnel selon la première direction et le dépôt de la deuxième partie (6 ; 6A) de la couche de matériau ferroélectrique (5) est mis en oeuvre par orientation d'un deuxième faisceau d'ions unidirectionnel selon la deuxième direction.

7. Procédé selon la revendication 6, dans lequel une modification de l'orientation du premier faisceau d'ions unidirectionnel et/ou du deuxième faisceau d'ions unidirectionnel est réalisée par inclinaison de la couche support (10).

8. Procédé selon la revendication 6 ou 7, dans lequel une modification de l'orientation du premier faisceau d'ions unidirectionnel et/ou du deuxième faisceau d'ions unidirectionnel est réalisée par inclinaison d'une cible à partir de laquelle sont formés le premier faisceau d'ions unidirectionnel et/ou le deuxième faisceau d'ions unidirectionnel.

9. Procédé selon l'une quelconque des revendications 1 à 8, dans lequel la couche de matériau ferroélectrique (5) comprend du dioxyde d'hafnium ou du dioxyde d'hafnium dopé par un élément dopant ou un alliage HfₓZr₁₋ₓO₂, avec 0<x<1.

10. Procédé selon l'une quelconque des revendications 1 à 9, dans lequel il est prévu, avant l'étape de dépôt de la deuxième couche (7), une étape d'implantation d'un élément dopant dans la couche de matériau ferroélectrique (5) de manière à doper la couche de matériau ferroélectrique (5) par l'élément dopant.
